Europäisches Patentamt

European Patent Office

Office européen des brevets

(19)

(11) Numéro de publication: **0 055 320**
**B1**

(12) **FASCICULE DE BREVET EUROPEEN**

(45) Date de publication du fascicule du brevet: **08.08.84**

(51) Int. Cl.³: **H 03 K 5/24, H 03 F 3/45**

(21) Numéro de dépôt: **80430032.5**

(22) Date de dépôt: **18.12.80**

(54) **Comparateur de tension ayant une large gamme de tension d'entrée de mode commun.**

(43) Date de publication de la demande:
**07.07.82 Bulletin 82/27**

(45) Mention de la délivrance du brevet:
**08.08.84 Bulletin 84/32**

(84) Etats contractants désignés:
**DE FR GB**

(56) Documents cités:
**DE - B - 1 239 729**
**US - A - 4 004 245**
**US - A - 4 037 170**

**IBM TECHNICAL DISCLOSURE BULLETIN vol. 16, fevrier 1974, Armonk, US N.G. THOMA: "Operational amplifier with high common-mode voltage capability", pages 2802-2803**

(73) Titulaire: **International Business Machines Corporation**
**Old Orchard Road**
**Armonk, N.Y. 10504 (US)**
(84) **DE GB**
(73) Titulaire: **Compagnie IBM FRANCE**
**5 Place Vendôme**
**F-75000 Paris 1er (FR)**
(84) **FR**

(72) Inventeur: **Orengo, Gérard**
**Les Hortensias "B" Chemin Ames du Purgatoire**
**F-06600 Antibes (FR)**
Inventeur: **Verhaeghe, Michel**
**30, Le Suve**
**F-06140 Vence (FR)**

(74) Mandataire: **Lattard, Nicole**
**Compagnie IBM France Département de Propriété Industrielle**
**F-06610 La Gaude (FR)**

## Description

Domaine Technique

La présente invention concerne un comparateur de tensions, ayant une gamme de tensions d'entrée de mode commun qui va au-delà de la plage des tensions comprises entre les tensions d'alimentation du comparateur.

Les comparateurs de tensions sont des dispositifs largement utilisés dans de nombreux systèmes, calculateurs, systèmes d'acquisition de données, systèmes de communication, etc. Actuellement, tous ces systèmes sont généralement réalisés sous forme de circuits intégrés de grande densité et en conséquence, il est indispensable de pouvoir inclure les comparateurs nécessaires dans le système sur des microplaquettes, mêmes si elles ne disposent que de certaines tensions d'alimentation.

Art Antérieur

On trouve un grand nombre de comparateurs décrits dans la littérature, chacun ayant ses caractéristiques propres. Par exemple, celui décrit dans la publication dans l'IBM "Technical Disclosure Bulletin" Vol. 21, No. 10, mars 1979, pages 4068—4069 présente une caractéristique de faible consommation de puissance. Ceux décrits dans l'ouvrage "Linear Applications" Vol. 1 par National Semiconducteurs, au chapitre AN-74 présentent des caractéristiques de vitesse de commutation moyenne et de fonctionnement à basse tension.

Ces dispositifs présentent un étage d'entrée différentiel comportant deux transistors à émetteurs couplés, les signaux d'entrée étant appliqués sur les bases de ces transistors. En conséquence, dans tous ces comparateurs la gamme des tensions d'entrée de mode commun est limitée aux valeurs des tensions d'alimentation, c'est-à-dire pour un comparateur alimenté entre 0 et 8,5 volts par exemple, la gamme des tensions d'entrée de mode commun est limitée à un volt environ au-dessus ou en-dessous de ces deux valeurs.

Le circuit amplificateur différentiel décrit dans le brevet US—A—4.004.245, comporte un étage d'entrée constitué de transistors à effet de champ dont les caractéristiques de tensions de claquage permettent d'étendre la gamme des tensions de mode commun au-delà des valeurs des tensions d'alimentation, et un étage intermédiaire classique comportant deux transistors dont les bases communes sont polarisées en tension.

Le circuit nécessite donc à la fois des transistors à effet de champ et bipolaires.

Résumé de l'Invention

En conséquence, un objet de la présente invention est de réaliser un comparateur dans lequel la gamme des tensions d'entrée de mode commun s'étend au-delà des valeurs des tensions d'alimentation qui ne comporte que des transistors bipolaires.

Un autre objet de la présente invention est de réaliser un comparateur présentant cette caractéristique de tensions d'entrée de mode commun élevées sans que cela affecte les autres paramètres caractéristiques du circuit.

Un autre objet de la présente invention est de réaliser un comparateur qui peut supporter des tensions d'entrée de mode commun négatives, même si ses tensions d'alimentation sont positives.

Le comparateur tel que caractérisé dans les revendications comporte essentiellement un étage d'entrée comportant deux transistors d'entrée dont les émetteurs sont reliés aux bornes d'entrée, dont les collecteurs sont connectés à deux sources de courant, et dont les bases reliées entre elles sont polarisées en courant,

un circuit de contrôle de courants pour fixer les courants continus collecteurs des transistors d'entrée à une première valeur I0 et les courants fournis par les sources de courants à une seconde valeur nI0 avec n>2,

un étage de sortie ayant deux entrées connectées aux collecteurs des deux transistors d'entrée et une sortie qui est mise à l'un ou l'autre des deux niveaux longiques haut ou bas suivant le signe de la différence des tensions appliquées sur les bornes d'entrée.

Si les premiers transistors sont des transistors NPN et que la tension d'alimentation est positive on peut étendre la gamme des tensions d'entrée de mode commun vers des valeurs de tension négative. Si par contre, ils sont du type PNP on peut l'étendre au-delà de la valeur de l'alimentation positive.

D'autres objets, caractéristiques et avantage de la présente invention ressortiront mieux de l'exposé qui suit fait en référence aux dessins annexés à ce texte, qui représentent plusieurs modes de réalisation préférés de celle-ci.

Brève Description des Figures

La Figure 1 représente le schéma simplifié d'un comparateur de tensions, montrant le principe de la présente invention.

Les Figures 2 et 3 représentent deux modes de réalisation du comparateur selon la Figure 1.

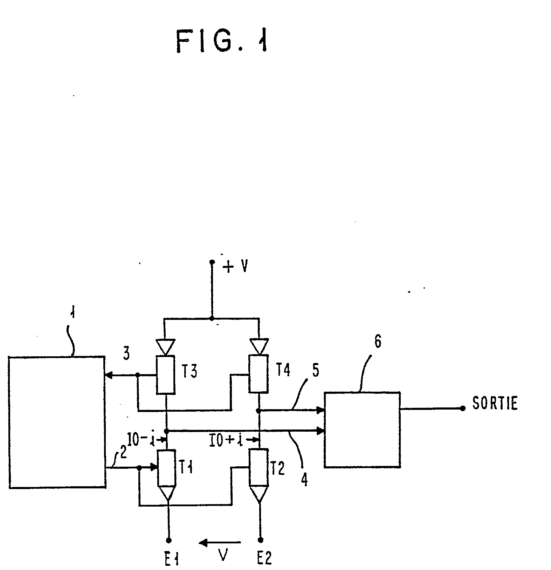

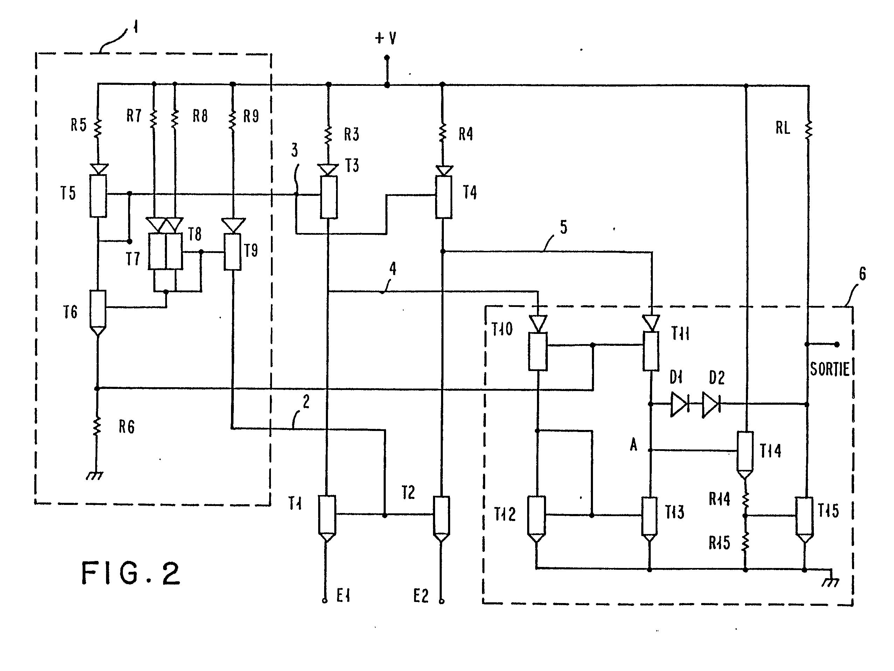

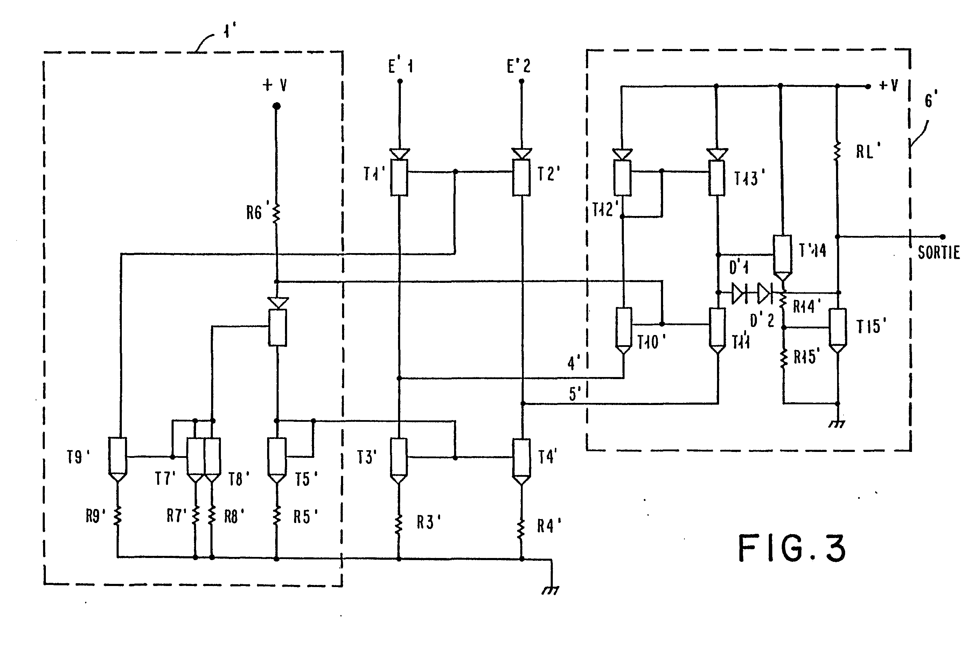

Sur la Figure 1, est représenté de façon schématique l'étage d'entrée d'un comparateur conforme à la présente invention. Il comprend deux transistors d'entrées T1 et T2 qui dans un mode de réalisation sont de type NPN. Les tensions d'entrée à comparer sont appliquées sur les émetteurs E1 et E2 respectivement, des deux transistors. Les transistors T1 et T2 sont disposés en série avec deux sources de courant qui dans un mode de réalisation préféré sont des transistors T3 et T4 de conductivité opposée à celle des premiers transistors. Les collecteurs des transistors T1 et T2 sont connectés aux collecteurs des transistors T3 et T4 respectivement. Un circuit 1, de contrôle de courants comporte deux lignes de sortie 2 et 3. Ces lignes de sortie sont connectées aux bases des transistors T1, T2 et T3, T4. Les transistors T1 et T2 ont leurs bases connectées ensemble et polarisés en courant par le circuit 1 par des moyens décrits en référence aux Figures 2 et 3. Les courants sur les lignes 3 et 2 sont tels que, lorsque les émetteurs E1 et E2 sont à la même tension, les courants collecteurs de T3 et T4 sont égaux, de même que les courants collecteurs de T1 et T2. De plus, les courants collecteurs I0 de T1 et T2, sont inférieurs aux courants collecteur I1 des transistors T3 et T4, ce qui peut s'écrire:

$$I1 = nI0 \text{ avec } n > 2.$$

Les émetteurs des transistors T3 et T4 sont reliés à la tension d'alimentation, +V qui dans le mode de réalisation décrit est positive. Les courant sur les connexions de sortie 4 et 5 prises aux points communs des collecteurs des transistors T1 et T3 et T2 et T4 respectivement sont appliqués à un étage de sortie.

Le schéma d'un étage de sortie et d'un circuit de contrôle de courants sont représentés en détail sur la Figure 2.

Le fonctionnement du circuit peut être expliqué en appliquant les règles de superposition des courants continus définis précédemment I1 et I0 et du courant i faible provoqué par un déséquilibre de tension sur les entrées E1 et E2. Si la tension sur l'entrée E1 est supérieure à celle sur l'entrée E2 le courant collecteur du transistor T1 sera I0 − i et les courant collecteur du transistor T2 sera I0 + i.

Inversement si la tension sur l'entrée E1 est inférieure à celle sur l'entrée E2, le courant collecteur du transistor T1 est I0 + i et celui du transistor T2 est I0 − i.

On peut vérifier que ce courant i, qui peut être soit positif, soit négatif, est fonction de la différence de tension v, entre les entrées E1 et E2 et que en conséquence il peut être exploité dans l'étage de sortie pour fournir un niveau logique haut ou bas suivant le signe de la différence entre les tensions sur les entrées E1 et E2.

On peut écrire:

$$v = V_{BE}(T2) - V_{BE}(T1)$$

$$v = kT/q \ln\frac{I0 + i}{I0 - i}$$

$V_{BE}(T1)$ et $V_{BE}(T2)$ étant les tensions base émetteur des transistors T1 et T2 respectivement,
k étant la constante de Boltzman,
q étant la charge électronique
T étant la température en dégré Kelvin.

En développant l'équation précédente et à condition que i soit bien inférieur à I0, on obtient:

$$v = \frac{kT}{q} \cdot \frac{2i}{I0}$$

On vérifie donc que i est l'image de la différence des tensions d'entrée. En particulier, si la tension d'entrée sur E1 est supérieure à la tension d'entrée sur E2, i sera positif. Inversement, si la tension d'entrée sur E2 est supérieure à la tension d'entrée sur E1, i sera négatif.

Le courant sur la connexion de sortie 4 est

$$nI0 - (I0 - i) = (n - 1)I0 + i,$$

celui sur la connexion 5 est

$$nI0 - (I0 + i) = (n - 1)I0 - i.$$

Les connexions 4 et 5 sont connectées à un étage de sortie 6, qui fournit le niveau logique associé, suivant les valeurs des tensions à comparer.

Le principal avantage du circuit de la figure 1, qui lui confère sa caractéristique de tension de mode commun élevé (qui sera évalué par la suite en référence à la figure 2) est que les entrées sont flottantes, l'étage d'entrée étant alimenté par une seule tension. De plus aucun des points sur lesquels les tensions peuvent varier, notamment les émetteurs et bases des transistors T1 et T2, ne sont soumis aux régles d'isolation qui doivent être respectivées pour l'intégration du dispositif suivant les règles classiques du procédé "planar". Ces règles peuvent être résumées de la manière suivante:

La tension collecteur d'un transistor NPN par rapport au substrat doit toujours être positive ou nulle.

La tension du lit épitaxique des résistances par rapport au substrat doit toujours être positive ou nulle.

La tension base d'un transistor PNP par rapport au substrat doit toujours être positive ou nulle.

On va maintenant décrire en référence à la figure 2, le schéma complet d'un comparateur conforme à l'invention, comprenant le circuit de contrôle des courants et un étage de sortie. Les éléments représentés sur la figure 1, qui se retrouvent dans la figure 2, portent les mêmes références.

Les deux transistors d'entrée T1 et T2 sont disposés comme sur la figure 1, en série avec les sources de courant constituées par les transistors T3 et T4 associés à des résistances R3 et R4 qui relient leurs émetteurs à la tension d'alimentation positive +V.

Le circuit de contrôle des courants, 1, comprend les transistors T5 à T9 et les résistances R5 à R9 arrangés de la façon suivante. Le transistor T5 de même type que les transistors T3 et T4 et appairé avec ces deux transistors, est disposé en miroir de courant avec les transistor T3 et T4. C'est-à-dire, il a son émetteur relié à la tension +V par une résistance R5 de même valeur que les résistances R3 et R4, sa base et son collecteur sont reliés ensemble, et les bases de T3, T4 et T5 sont reliées. Du fait de ce montage, les tensions base-émetteur des trois transistors sont égales et en conséquence leurs courants collecteurs I1 sont égaux.

Un transistors NPN, T6 a sont collecteur relié au collecteur du transistor T5, son émetteur relié à la masse par la résistance R6. Le courant collecteur du transistor T6 étant égal à I1, son courant base est $I1/\beta n$, $\beta n$ étant le gain du transistor NPN T6. Le transistor T6 est appairé avec les transistors T1 et T2 qui ont donc le même gain $\beta n$ que lui.

Les courants bases des transistors T1 et T2 sont générés à parti de ce courant $I1/\beta n$ par un second miroir de courant comprenant les transistors T7, T8 et T9. Les transistors T7 et T8 ont leurs collecteurs reliés ensemble et connectés à la base du transistor T6, ainsi bases leurs qu'à respectives et leurs émetteurs sont connectés par les résistances R7 et T8 à la tension positive +V. Le transistor T9 a sa base reliée à celles des transistors T7 et T9, son émetteur relié par une résistance R9 de même valeur que R7 et R8 à la tension positive +V et son collecteur connecté aux bases des transistors T1 et T2. En conséquence, le courant collecteur du transistor T9 est égal à $I1/2\beta n$.

Les courants bases des deux transistors T1 et T2 sont donc égaux à $I1/4\beta n$. Les transistors T1 et T2 ayant les mêmes gains que le transistor T6, leurs courants collecteur sont égaux à $I1/4$. On obtient ainsi un courant $I1 = nI0 = 4I0$.

On peut obtenir d'autres rapports entre les courants I1 et I0 pour cela il suffit de choisir les rapports des résistances émetteurs ou de mettre d'autres transistors en parallèle avec T7 et T8.

L'étage de sortie 6, reçoit par les connexions 4 et 5, les courants $3I0 \pm i$ générés suite à l'application des tensions à comparer sur les entrées E1 et E2.

Deux transistors PNP T10 et T11, one leurs émetteurs reliés aux connexions 4 et 5 respectivement, leurs bases reliées ensemble et polarisées par la tension prise à l'émetteur du transistor T6 qui est égale à $+V - 2V_{BE}$ ($V_{BE}$ étant la tension base-êmetteur d'un transistor, approximativement égale à 0,7 volts).

Les collecteurs des transistors T10 et T11 sont connectés aux collecteurs de deux transistors NPN T12 et T13. Les transistors T12 et T13 ont leurs bases connectées ensemble et leurs émetteurs reliés à la masse. Le collecteur de T12 est connecté aux bases de T12 et T13. Le collecteur du transistor T13 est connecté à la base d'un transistor NPN T14 dont l'émetteur est connecté par deux résistances R14 et R15 en série à la masse. Le collecteur du transistor T14 est connecté à la tension +V. Un transistor de sortie NPN T15 a son émetteur relié à la masse et sa base reliée au point commun des résistances R14 et R15 dont les valeurs sont choisies pour que la tension sur l'émetteur de T14 soit égale à $1,5V_{BE}$, lorsque T14 et T15 sont conducteurs. La sortie est prise au collecteur du transistor T15, connectée par une résistance de charge RL à la tension +V. Deux diodes d'anti-saturation D1 et D2 sont disposées en série entre les collecteurs des transistors T11 et T15, l'anode de D1 étant connectée au collecteur du transistor T11 et la cathode de D2 étant connectée au collecteur du transistor T15.

Le fonctionnement de l'étage de sortie est le suivant. Comme on l'a expliqué en référence à la figure 1, si VE1 est supérieur à VE2, le courant sur la connexion 4 est $3I0 + i$ et sur la connexion 5, $3I0 - i$.

Le courant $3I0 + i$ se retrouve dans le chemin collecteur du transistor T12 et est recopié dans le chemin collecteur du transistor T13. Le courant $3I0 - i$ à l'émetteur de T11 se retrouve dans le chemin collecteur de ce même transistor. En conséquence, aucun courant n'est fourni à la base du transistor T14 qui est bloqué. Le transistor T15 est lui aussi bloqué et la tension de sortie est au niveau haut.

Inversement, si la tension VE1 est inférieure à VE2, le courant à l'émetteur de T10 est $3I0 - i$, il est recopié dans le chemin collecteur de T12, le courant à l'émetter du transistor T11 est $3I0 + i$, en conséquence, un courant $2i$ est amené à la base du transistor T14 qui conduit. Le transistor T15 conduit lui aussi et la tension de sortie est au niveau bas.

Dans cette structure, la gamme des tensions d'entrée de mode commun est principalement limitée par les tensions de claquage des transistors. Notamment, la valeur limite négative de la tension d'entrée de mode commun est égale à

$$+V - [BVCEO(T9) + V_{BE}(T1 \text{ ou } T2)]$$

BVCEO (T9) étant la tension de claquage entre collecteur et émetteur du transistor T9.

Cette tension de claquage dépend naturellement de la technologie utilisée pour fabriquer la structure semi-conductrice. A titre d'exemple, avec une tension de claquage collecteur émetteur de 13 volts et une tension d'alimentation de 5 volts, on obtient une limite inférieure de la gamme des tension de mode commun de −8,7 volts.

La limite supérieure de cette gamme est $+V - 2V_{BE}$, ce qui donne pour $+V = 5$ volts une valeur limite supérieure de 3,6 volts.

Le principe de la présente invention peut aussi être appliqué avec des transistors du type de conductivité opposé notamment pour les transistors d'entrée qui peuvent être du type PNP, il est bien évident que ceci implique un changement du type de conductivité pour les autres transistors de l'ensemble.

Sur la figure 3 est représenté le schéma d'un tel comparateur. Les éléments remplissant les mêmes fonctions que dans la figure 2 ont les mêmes références avec un signe prime.

Les transistors d'entrée T2' et T1' sont des transistors PNP, aux émetteurs desquels sont appliquées les tensions à comparer. Leurs collecteurs sont connectés aux collecteurs de deux transistors NPN T4' et T3' dont les émetteurs sont connectés à la masse par les résistances R4' et R3'. Le circuit de contrôle des courants comprend les transistors T5' à T9' de conductivité opposée aux transistors correspondants dans la figure 2. Les émetteurs des transistors NPN, T5', T7', T8' et T9' sont reliés à la masse par des résistances R5', R7', R8' et R9' et l'émetteur du transistor PNP T6' est connecté à la tension d'alimentation positive par la résistance R6'.

Les connexions 4' et 5' sont reliées aux émetteurs des transistors NPN T10' et T11'. Deux transistors PNP, T12' et T13' ont leurs collecteurs connectés aux collecteurs des transistors T10' et T11' et leurs émetteurs reliés à la tension positive. L'étage de sortie est construit suivant le même principe que celui de la figure 2. Le transistor de sortie T14' est de type NPN avec son collecteur connecté à la tension +V et son émetteur connecté à la masse par les résistances R14' et R15'. Le transistor T15' est de même type de conductivité que le transistor T15 et il est disposé de la même façon que sur la figure 2.

Le fonctionnement du circuit de la figure 3 est identique à celui du circuit de la figure 2, c'est-à-dire le circuit de contrôle des courants, fait qu'un courant 4I0 circule dans les chemins collecteurs des transistors T3' et T4' et un courant I0 circule dans les chemins collecteurs des transistors T1' et T2'.

Si la tension VE1' est supérieure à VE2', le courant collecteur de T1' est I0 + i et le courant collecteur de T2' est I0 − i. En conséquence, le courant sur la connexion 4' est 3I0 − i et celui sur la connexion 5' est 3I0 + i.

Le courant collecteur 3I0 − i du transistor T10' est recopié par l'arrangement des transistors T12' et T13' dans le chemin collecteur du transistor T13', le courant 3I0 + i se retrouve dans le chemin collecteur du transistor T11, en conséquence, le transistor T14' est bloqué de même que le transistor T15' et la sortie est haute. Inversement, si la tension VE1' est inférieure à VE2', le transistor T14' est conducteur et la sortie est basse.

Avec ce montage, la gamme des tensions d'entrée de mode commun est différente. Elle est étendue vers les valeurs positives au-dessus de la tension +V. Elle est comprise entre $2V_{BE}$ et $[BVCEO + V_{BE}]$ par rapport à la masse.

A titre d'exemple, avec une tension de claquage collecteur-émetteur de 13 volts et une tension d'alimentation de 5 volts, on obtient une limite supérieure de la gamme des tensions de mode commun de +13,7 volts.

**Revendications**

1. Comparateur de tensions ayant deux bornes d'entrée (E1, E2) recevant les tensions à comparer, un étage d'entrée comportant deux transistors d'entrée (T1, T2) dont les émetteurs sont reliés aux bornes d'entrée (E1, E2), dont les collecteurs sont connectés à deux sources de courant (T3, T4), et dont les bases reliées entre elles sont polarisées en courant, caractérisé en ce qu'il comprend: un circuit de contrôle de courants (1) pour fixer les courants continus collecteurs des transistors d'entrée (T1, T2) à une première valeur I0 et les courants fournis par les sources de courants (T3, T4) à une seconde valeur nI0 avec n>2, un étage de sortie (6) ayant deux entrées (4) et (5) connectées aux collecteurs des deux transistors d'entrée (T1, T2) et une sortie qui est mise à l'un ou l'autre des deux niveaux logiques haut ou base suivant le signe de la différence des tensions appliquées sur les bornes d'entrée (E1, E2).

2. Comparateur selon la revendication 1 caractérisé en ce que les transistors d'entrées (T1, T2) sont de type NPN et les sources de courants (T3, T4) sont des transistors PNP ayant leurs émetteurs connectés à une première tension d'alimentation, leurs collecteurs connectés aux collecteurs des transistors d'entrée (T1, T2) et leurs bases connectées ensemble au circuit de contrôle de courants (1).

3. Comparateur selon la revendication 2 caractérisé en ce que le circuit de contrôle de courants (1) comprend: un premier transistor PNP (T5) ayant sa base connectée aux bases des transistors sources de courant (T3) et (T4) son émetteur relié à la première tension d'alimentation et sa base reliée à son collecteur, un second transistor NPN (T6) ayant son collecteur connecté au collecteur du premier transistor et son émetteur relié à une seconde tension d'alimentation, par une résistance (R6), un miroir de courant ayant deux branches, la première branche connectée à la base du second transistor (T6), et comportant au moins deux troisièmes transistors (T7, T8) de type PNP ayant leurs émetteurs connectés à la première tension d'alimentation, leur bases connectées à leurs collecteurs et à la base du second transistor (T6) et la seconde branche connectée aux bases des transistors d'entrée (T1, T2) et comprenant un quatrième transistor (T9) appairé avec les troisièmes transistors (T7, T8), ayant sa base connectée aux bases des troisièmes transistors (T7, T8), son collecteur relié aux bases des transistors d'entrée (T1, T2) et son émetteur relié à la première tension d'alimentation.

4. Comparateur selon la revendication 3 caractérisé en ce que la première tension d'alimentation est positive par rapport à la seconde.

5. Comparateur selon la revendication 1, caractérisé en ce que les transistors d'entrée sont des transistors de type PNP (T1', T2') et les sources de courant sont des transistors de type NPN (T3', T4'), ayant leurs émetteurs connectés à une première tension d'alimentation leurs collecteurs connectés aux collecteurs des transistors d'entrée (T1', T2') et leurs bases connectées ensemble au circuit de contrôle de courants (1').

6. Comparateur selon la revendication 5 caractérisé en ce que le circuit de contrôle de courants (1') comprend: un premier transistor (T5') de type NPN ayant sa base connectée aux bases des trransistors sources de courant (T3'), (T4'), son émetteur relié à la première tension d'alimentation et sa base reliée à son collecteur, un second transistor (T6') ayant son collecteur connecté au collecteur du premier transistor (T5') et son émetteur relié à une seconde tension d'alimentation, par une résistance (R6'), un miroir de courant ayant deux branches, la première connectée à la base du second transistor (T6') et comportant au moins deux troisièmes transistors (T7', T8') de type NPN, ayant leurs émetteurs reliés à la seconde tension d'alimentation, leurs bases connectées à leurs collecteurs et à la base du second transistor (T6'), et la seconde branche connectée aux bases des transistors d'entrée (T1', T2') comprenant un quatrième transistor (T9') appairé avec les troisièmes transistors (T7', T8'), et ayant sa base connectée aux bases des troisièmes transistors (T7', T8'), son collecteur relié aux bases des transistors d'entrée (T1', T2') et son émetteur relié à la première tension d'alimentation.

7. Comparateur selon la revendication 7 caractérisé en ce que la première tension d'alimentation est positive par rapport à la seconde.

**Patentansprüche**

1. Spannungskomparator mit zwei Eingangsklemmen (E1, E2), zu den die zu vergleichenden Spannungen angelegt sind, mit einer Eingangsstufe, die zwei Eingangstransistoren (T1, T2) aufweist, deren Emitter mit den Eingangsklemmen (E1, E2) und deren Kollektoren mit zwei Stromquellen (T3, T4) verbunden sind, und deren miteinander verbundenen Basen mittels Strom vorgespannt sind, dadurch gekennzeichnet, dass er aufweist: einen Stromkontrollkreis (1), um die Kollektor, Gleichstroeme der Eingangstransistoren (T1, T2) auf einen ersten Wert I0 und die Stroeme aus den Stromquellen (T3, T4) auf einem zweiten Wert nI0 einzusetzen, wo n>2 ist, eine Ausgangsstufe (6) mit zwei mit den Kollektoren der zwei Eingangstransistoren (T1, T2) verbundenen Eingaengen (4) und (5) und mit einem Ausgang, der in Abhaengigkeit von dem Zeichen der Differenz der an den Eingangsklemmen (E1, E2) angelegten Spannungen auf dem einen hohen oder dem anderen niedrigen logischen Pegel gesetzt ist.

2. Spannungskomparator nach Anspruch 1, dadurch gekennzeichnet, dass die Eingangstransistoren (T1, T2) NPN-Transistoren und die Stromquellen (T3, T4) PNP-Transistoren sind, deren Emitter mit einer ersten Zufuhrspannung und deren Kollektoren mit den Kollektoren der Eingangstransistoren (T1, T2) verbunden sind, und deren Basen mit dem Stromkontrollkreis (1) zusammen verbunden sind.

3. Spannungskomparator nach Anspruch 2, dadurch gekennzeichnet, dass der Stromkontrollkreis (1) aufweist: einen ersten PNP-Transistor (T5), dessen Basis mit den Basen der Stromquellen-Transistoren (T3 und T4), dessen Emitter mit der ersten Zufuhrspannung und dessen Basis mit einem Kollektor verbunden ist, einen zweiten NPN-Transistor (T6), dessen Kollektor mit dem Kollektor des ersten Transistors und dessen Emitter mit einer zweiten Zufuhrspannung mittels eines Widerstands (R6) verbunden ist, einen Stromspiegel mit zwei Zweigen, wo sein erster Zweig mit der Basis des zweiten Transistors (T6) verbunden ist und mindestens zwei dritte PNP-Transistoren (T7, T8) aufweist, deren Emitter mit der ersten Zufuhrspannung, deren Basen mit den Kollektoren und mit der Basis des zweiten Transistors (T6) verbunden sind, wo sein zweiter Zweig mit den Basen der Eingangstransistoren (T1, T2) und einen vierten mit den dritten Transistoren (T7, T8) gepaarten Transistor (T9) aufweist, dessen Basis mit den Basen der dritten Transistoren (T7, T8), dessen Kollektor mit den Basen der Eingangstransistoren (T1, T2) und dessen Emitter mit der ersten Zufuhrspannung verbunden ist.

4. Spannungskomparator nach Anspruch 3, dadurch gekennzeichnet, dass die erste Zufuhrspannung im Verhaeltnis zu der zweiten positiv ist.

5. Spannungskomparator nach Anspruch 1, dadurch gekennzeichnet, dass die Eingangstransistoren PNP-Transistoren (T1', T2') und die Stromquellen NPN-Transistoren (T3', T4') sind, deren Emitter mit einer ersten Zufuhrspannung, deren Kollektoren mit den Kollektoren der Eingangstransistoren (T1', T2') und deren Basen mit dem Stroemenkontrollkreis (1') verbunden sind.

6. Spannungskomparator nach Anspruch 5, dadurch gekennzeichnet, dass der Stroemenkontrollkreis (1') aufweist: einen ersten NPN-Transistor (T5'), dessen Basis mit den Basen der Stromquellen-Transistoren (T3', T4'), dessen Emitter mit der ersten Zufuhrspannung et dessen Basis mit seinem Kollektor verbunden ist, einen zweiten Transistor (T6'), dessen Kollektor mit dem Kollektor des ersten Transistors (T5') und dessen Emitter mit einer zweiten Zufuhrspannung mittels eines Widerstands (R6') verbunden ist, einen Stromspiegel mit zwei Zweigen, wo sein erster Zweig mit der Basis des Zweiten Transistors (T6') verbunden ist und mindestens zwei dritte PNP-Transistoren (T7', T8') aufweist, deren Emitter mit der zweiten Zufuhrspannung, deren Basen mit deren eigenen Kollektoren und mit der Basis des zweiten Transistors (T6') verbunden sind, wo sein zweiter Zweig mit den Basen der Eingangstransistoren (T1', T2') und einen vierten mit den dritten Transistoren (T7', T8') gepaarten Transistor (T9') aufweist, dessen Basis mit den Basen der dritten Transistoren (T7', T8'), und dessen Kollektor mit den Basen der Eingangstransistoren (T1', T2') und dessen Emitter mit der ersten Zufuhrspannung verbunden ist.

7. Spannungskomparator nach Anspruch 6, dadurch gekennzeichnet, dass die erste Zufuhrspannung im Verhaeltnis zu der zweiten positiv ist.

## Claims

1. A voltage comparator provided with two terminals (E1 and E2) for receiving the voltages to be compared, an input stage consisting or two input transistors (T1 and T2) whose emitters are connected to the input terminals (E1, E2) and whose collectors are connected to two current sources (T3 and T4) and whose interconnected bases are current biased, characterized in that it includes: a current monitoring circuit (1) to fix the collector direct currents of the input transistors (T1, T2) at a first value 10 and the currents supplied by the current sources (T3, T4) at a second value of n10 with n>2, an output stage (6) with two inputs (4) and (5) connected to the collectors of the two input transistors (T1, T2), and one output which is set to either one of the two logic levels up or down depending on the sign of the difference of the voltages applied to the input terminals (E1, E2).

2. A comparator according to claim 1, characterized in that the input transistors (T1, T2) are of the NPN type and the current sources (T3, T4) are PNP transistors whose emitters are connected to a first supply voltage, whose collectors are connected to the collectors of the input transistors (T1, T2) whose bases are connected together to the current monitoring circuit (1).

3. A comparator according to claim 2, characterized in that the current monitoring circuit (1) includes: a second NPN transistor (T6) whose collector is connected to the collector of the first transistor and whose emitter is connected to a second supply voltage via a resistor (R6), a current mirror having two legs, the first leg being connected to the base of the second transistor (T6), and provided with at least two third transistors (T7, T8) of the PNP type, whose emitters are connected to the first supply voltage and whose bases are connected to their collectors and to the base of the second transistor (T6), the second leg being connected to the bases of the input transistors (T1, T2) and comprising a fourth transistor (T9) paired with the third transistors (T7, T8), whose base is connected to the bases of the third transistors (T7, T8), whose collector is connected to the bases of the input transistors and whose emitter is connected to the first supply voltage.

4. A comparator according to claim 3, characterized in that the first supply voltage is positive with respect to the second one.

5. A comparator according to claim 1, characterized in that the input transistors are PNP-type transistors (T1', T2') and that the current sources are NPN-type transistors (T3', T4') whose emitters are connected to a first supply voltage whose collectors are connected to the collectors of the input transistors (T1', T2'), and whose bases are connected together to the current monitoring circuit (1').

6. A comparator according to claim 5, characterized in that the monitoring circuit (1') includes: a first transistor (T5') of the NPN type whose base is connected to the bases of the current source transistors (T3'), (T4'), whose emitter is connected to the first supply voltage and whose base is connected to its collector, a second transistor (T6') whose collector is connected to the collector of the first transistor (T5') and whose emitter is connected to a second supply voltage via a resistor (R6'), a current mirror having two legs, the first one being connected to the base of the second transistor (T6') and comprising at least two third transistors (T7', T8') of the NPN type, whose emitters are connected to the second supply voltage, whose bases are connected to their collectors and to the base of the second transistor (T6') and, the second one being connected to the bases of the input transistors (T1', T2') comprising a fourth transistor (T9') paired with the third transistors (T7', T8'), whose base is connected to the bases of the third transistors (T7', T8'), and whose emitter is connected to the first supply voltage, and whose collector is connected to the bases of the input transistors (T1', T2').

7. A comparator according to claim 6, characterized in that the first supply voltage is positive with respect to the second one.

# FIG. 1

FIG.2

FIG.3

0 055 320